# EUROPÄISCHE PATENTANMELDUNG

(11) **EP 1 865 330 A2**
(43) Veröffentlichungstag der Anmeldung: **12.12.2007**
(21) Anmeldenummer: 07109617.6
(22) Anmeldetag: 05.06.2007
(51) Int. Cl.: G01R 1/067, G01R 15/20

(54) **System zur Ermittlung von Störungen in elektrischen Leitern**

(30) Priorität: 09.06.2006 AT 4552006 U
(71) Anmelder: DiTest Fahrzeugdiagnose GmbH, 8020 Graz (AT)
(72) Erfinder: Gutkauf, Bernd, 8053 Graz (AT)
(74) Vertreter: Laminger, Norbert

(57) **Zusammenfassung**

Ein System zur Ermittlung von Störungen in elektrischen Leitern besteht aus einer an den Leiter anschließbaren Signalquelle (11 bis 18), die ein genau definiertes, begrenztes Stromsignal liefert, sowie einer Signalerfassungseinheit (1 bis 5) zur berührungslosen Erfassung von Stromfluß im Leiter, welche in Form eines schmal zulaufenden Stiftes gestaltet ist, an dessen Ende zumindest eine allenfalls verschließbare Durchgangsöffnung (1 bzw. 2) für den Leiter (1a) vorgesehen ist, wobei im Bereich der Ausnehmung (1 bzw. 2) ein Sensor für die elektromagnetischen Felder des umfassten Leiters (1a) vorgesehen ist.

## Beschreibung

System zur Ermittlung von Störungen in elektrischen Leitern, umfassend eine an den Leiter anschließbare Signalquelle und eine Signalerfassungseinheit zur berührungslosen Erfassung von Stromfluß im Leiter.

Solche Systeme sind beispielsweise als Leitungssuchgeräte mit Möglichkeit zur Funktionsüberprüfung der etwa in Mauerwerk verlegten Leitungen bekannt. Diese Systeme sind jedoch meist nur für Wechselstrom ausgelegt. Darüberhinaus sind sie für die Prüfung mehrerer unmittelbar benachbarter Leiter aufgrund von deren Streufelder nicht anwendbar. Auch die Empfindlichkeit bei geringen Strömen ist begrenzt.

Für den speziellen Anwendungsbereich der Prüfung von einzelnen Leitern eines Kabelbaumes und das Auffinden von Kurzschlüssen wird bislang meist die Vorgangsweise angewendet, durch Lösen von Verbindungen und nachfolgendem Einsetzen von Sicherungen zu kontrollieren, ob der Kurzschluss noch vorhanden ist. Diese treten vermehrt bei mechanisch bewegten Teilen, wie beispielsweise im Motorraum, bei den Fahrzeugtüren, etc. auf, welche zur Signalübertragung mit elektrischen Leitungen verbunden sind. Das herkömmliche Verfahren hat einen hohen Verbrauch an Sicherungen, birgt die Gefahr eventueller weiterer Beschädigung von Bauteilen in sich, und erfordert großen Zeitaufwand.

Daher war die Aufgabe der vorliegenden Erfindung, ein System anzugeben, welches den obigen Nachteilen begegnet und das einfache, rasche und sichere Detektieren von Leitungs- und Massekurzschlüssen, insbesonders im KFZ-Bereich, ermöglicht.

Zur Lösung dieser Aufgabe ist das eingangs beschriebene System erfindungsgemäß dadurch gekennzeichnet, daß die Signalerfassungseinheit in Form eines schmal zulaufenden Stiftes gestaltet ist, an dessen Ende zumindest eine allenfalls verschließbare Durchgangsöffnung für den Leiter vorgesehen ist, wobei im Bereich der Ausnehmung ein Sensor für die elektromagnetischen Felder des umfassten Leiters vorgesehen ist. Zur Detektion mittels elektromagnetischer Kopplung kommt ein stiftähnlicher Sensor zum Einsatz, der im Gegensatz zu den herkömmlichen Stromzangen mit großen geometrischen Abmessungen die Möglichkeit bietet, einfach entlang einzelner Leitungen eines Kabelbaumes geführt zu werden. Durch das Umfassen jeweils eines Leiters können die Einflüsse der Streufelder benachbarter Leiter weitestgehend verringert werden. Durch sukzessives Abtasten der Leitungen, kann so die Stelle des Kurzschlusses gefunden werden.

Wenn gemäß einer vorteilhaften Ausführungsform die Durchgangsöffnung für den Leiter im wesentlichen U-förmig nach einer Seite offen ausgeführt ist, können die Leiter einfach abgetastet werden, ohne daß sie gelöst oder zerschnitten werden müssen, so daß auch durch Bleche, Wände od. dgl. hindurchführende Leiter einfach entlang ihres gesamten Verlaufes geprüft werden können.

Um auch den Stromfluß bei Gleichspannung überprüfen zu können, ist vorteilhafterweise vorgesehen, daß der Sensor für die elektromagnetischen Felder des umfassten Leiters ein Hall-Element ist.

Vorzugsweise ist die Signalerfassungseinheit mit einer autarken Energieversorgung ausgerüstet.

Für den autarken Betrieb vorteilhaft ist auch die erfindungsgemäße Ausführungsform des Systems, bei welcher die Signalerfassungseinheit mit einer eigenen optischen und/oder akustischen Anzeigeeinrichtung ausgestattet ist. Über diese optische oder akustische Signaleinrichtung wird ein Stromfluss angezeigt.

Vorteilhafterweise kann vorgesehen sein, daß die Signalerfassungseinheit eine Anschlussbuchse für eine Signalleitung aufweist. Da speziell mit geschlossenen Messdurchgängen eine sehr genaue Strommessung möglich ist, kann in diesen Fällen das Stromsignal zur genaueren Analyse über die Signalleitung an eine Signalverarbeitungs- und/oder -anzeigeeinheit, beispielsweise ein Multimeter, übertragen werden.

Gemäß einem weiteren Merkmal der Erfindung ist vorgesehen, daß die Signalquelle ein genau definiertes, begrenztes Stromsignal liefert. Dieses Stromsignal kann durch einen internen oder externen Energiespeicher zur Verfügung gestellt werden und wird über zwei einfach zugängliche Einspeisepunkte, bei Kraftfahrzeugen vorzugsweise im Sicherungskasten, eingespeist. Als externer Energiespeicher kann beispielsweise die Autobatterie genutzt werden, etwa über den Zigarettenanzünder oder andere vorhandene Steckdosen für Zubehör.

Vorteilhafterweise kann vorgesehen sein, daß die Signalquelle ein zeitlich begrenztes Stromsignal, allenfalls periodisch, mit besonderem Signalverlauf oder auf Abruf, liefert. Der besondere Signalverlauf kann für die einfachere Detektierung und Unterscheidung von anderen Signalquellen vorteilhaft sein.

Wenn die Signalquelle einen Strombegrenzer beinhaltet, kann die Beschädigung von Bauteilen vermieden werden, falls Spannung auf den mutmaßlich fehlerhaften Leitungen anliegt.

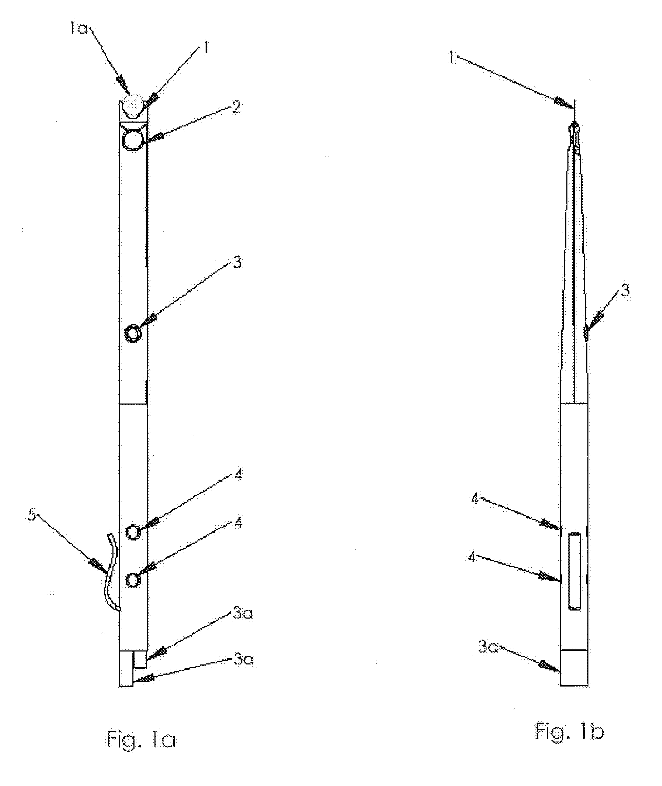

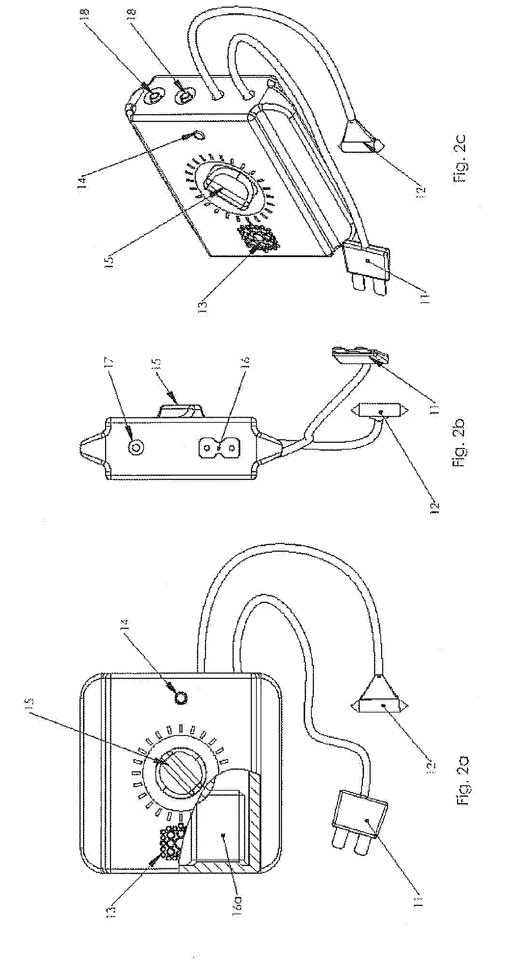

In der nachfolgenden Beschreibung wird die Erfindung unter Bezugnahme auf die beigefügten Zeichnungen näher erläutert werden. Dabei zeigt die Fig. 1a eine erfindungsgemäße Signalerfassungseinheit in einer Ansicht in Richtung der Durchgangsöffnung für den Leiter, Fig. 1b ist eine Ansicht der Signalerfassungseinheit normal auf die Ansicht der Fig. 1a, Fig. 2a ist eine Draufsicht auf eine erfindungsgemäße Signalquelle, teilweise geschnitten, Fig. 2b ist eine Seitenansicht dieser Signalquelle und Fig. 2c ist eine perspektivische Ansicht der Signalquelle der Fig. 2a und 2b.

Die in den Fig. 1a und 1b dargestellte Signalerfassungseinheit zur berührungslosen Erfassung von Stromfluß in einem Leiter 1a ist vorteilhafterweise in Form eines schmal zulaufenden Stiftes, vorzugsweise mit einer Befestigungsklammer 5, gestaltet. An einem Ende ist nun ein erster Durchgang für den Leiter 1a vorgesehen, welcher Durchgang als offene Messgabel 1 ausgeführt sein kann, welche einen Leiter teilweise umgreifen kann. Derartige offene Durchgänge 1 sind ausreichend, wenn die allein eine Feststellung erfolgen soll, ob Stromfluß vorhanden ist oder nicht.

Durch ein möglichst vollständiges Umfassen des Leiters 1a, vorzugsweise mittels des weiteren, geschlossenen Messdurchganges 2, können die Einflüsse der Streufelder benachbarter Leiter weitestgehend verringert werden, so daß auch die genau Bestimmung von Stromstärke und Verlauf ermöglicht ist. Besonders vorteilhaft ist daher eine Ausführungsform der Signalerfassungseinheit, bei welcher über ein Betätigungselement, wie beispielsweise einen Drücker 3a am den Durchgängen 1, 2 für den Leiter 1a entgegengesetzten Ende, die Messgabel 1 axial nach vorne geschoben und dadurch der Durchgang 2 geöffnet werden kann, um den Leiter 1a zu umgreifen. Danach wird der Drücker 3a wieder losgelassen, die Messgabel 1 fährt wieder in die Ausgangsstellung zurück und der Messdurchgang 2 wird wieder unter vollständiger Umschließung des Leiters 1a geschlossen.

Im Bereich der Messgabel 1 bzw. des Messdurchganges 2 ist in jedem Fall ein Sensor (nicht dargestellt), vorzugsweise ein Hall-Element, für die elektromagnetischen Felder des umfassten Leiters 1a vorgesehen.

Ein weiteres Betätigungselement, meist in Form eines Tasters 3, vorzugsweise im Bereich der Längsmitte der Signalerfassungseinheit angeordnet, dient zum Ein- und Ausschalten der Signalerfassungseinheit, welche vorzugsweise auch mit einer (ebenfalls nicht dargestellten) autarken Energieversorgung ausgerüstet ist. Die Detektion von elektromagnetischen Feldern um den Leiter 1a, allenfalls auch die Funktionsbereitschaft und/oder der Status der autarken Energieversorgung, kann über die optischen Anzeigeeinrichtungen 4 in Form von LEDs angezeigt werden. Alternativ oder zusätzlich können aber auch akustische Anzeigeeinrichtungen, umfassend Tongeneratoren und Lautsprecher in der Signalerfassungseinheit, vorgesehen sein.

Nicht dargestellt ist in den Zeichnungen der Signalerfassungseinheit eine auch denkbare Anschlussbuchse für eine Signalleitung, über welche Signalleitung das Stromsignal zur genaueren Analyse an eine Signalverarbeitungs- und/oder - anzeigeeinheit übertragen werden kann.

Zur Lieferung eines genau definierten, begrenzten Stromsignals in den Leiter 1a dient die in den Fig. 2a bis 2c beispielhaft dargestellte Signalquelle. Über Anschlüsse 11 und/oder 12 vorzugsweise in der Form von in Kraftfahrzeugen gebräuchlichen Sicherungen kann von der Signalquelle vorteilhafterweise ein zeitlich begrenztes Stromsignal, allenfalls periodisch oder auf Abruf, in den Leiter 1a oder einen gesamten Leiterbaum eingespeist werden. Das Stromsignal kann auch einen besonderen zeitlichen Verlauf aufweisen, beispielsweise Rechteck- oder Sägezahnform aufweisen, um es einfach und sicher von anderen Stromsignalen unterscheiden zu können. Die Signalquelle kann vorzugsweise auch einen Strombegrenzer beinhalten. Die Funktionsbereitschaft und/oder den Status der Energieversorgung, allenfalls auch einen Stromfluß, zeigen eine optische Anzeigeeinrichtung in Form eines Kontrolllämpchens oder einer LED 14 und/oder eine akustische Signaleinrichtung über den Lautsprecher 13 an. Zumindest ein Parameter des Signals kann über ein Betätigungselement wie beispielsweise einen Dreh-Wahlschalter 15 eingestellt werden.

Die Signalquelle kann mit einer autarken Energieversorgung ausgestattet sein, kann aber zur Energieversorgung während des Betriebes und/oder zum Aufladen eines internen Energiespeichers an externe Energiequellen angeschlossen werden. Dazu dienen Buchsen 16 für den Anschluß an 230 V Wechselstrom bzw. 17 für den Anschluß an das Bordnetz des Fahrzeuges, beispielsweise über den Zigarettenanzünder. Buchsen 18 können für den Abgriff einer Versorgungsspannung und für die Strombegrenzung vorgesehen sein.

## Patentansprüche

1. System zur Ermittlung von Störungen in elektrischen Leitern, umfassend eine an den Leiter anschließbare Signalquelle und eine Signalerfassungseinheit zur berührungslosen Erfassung von Stromfluß im Leiter, **dadurch gekennzeichnet, daß** die Signalerfassungseinheit (1 bis 5) in Form eines schmal zulaufenden Stiftes gestaltet ist, an dessen Ende zumindest eine allenfalls verschließbare Durchgangsöffnung (1 bzw. 2) für den Leiter (1a) vorgesehen ist, wobei im Bereich der Ausnehmung (1 bzw. 2) ein Sensor für die elektromagnetischen Felder des umfassten Leiters (1a) vorgesehen ist.

2. System nach Anspruch 1, **dadurch gekennzeichnet, daß** die Durchgangsöffnung (1) für den Leiter (1a) im wesentlichen U-förmig nach einer Seite offen ausgeführt ist.

3. System nach Anspruch 1 oder 2, **dadurch gekennzeichnet, daß** der Sensor für die elektromagnetischen Felder des umfassten Leiters (1a) ein Hall-Element ist.

4. System nach einem der Ansprüche 1 bis 3, **dadurch gekennzeichnet, daß** die Signalerfassungseinheit (1 bis 5) mit einer autarken Energieversorgung ausgerüstet ist.

5. System nach einem der Ansprüche 1 bis 4, **dadurch gekennzeichnet, daß** die Signalerfassungseinheit (1 bis 5) mit einer eigenen optischen (4) und/oder akustischen Anzeigeeinrichtung ausgestattet ist.

6. System nach einem der Ansprüche 1 bis 5, **dadurch gekennzeichnet, daß** die Signalerfassungseinheit (1 bis 5) eine Anschlussbuchse für eine Signalleitung aufweist.

7. System nach einem der Ansprüche 1 bis 5, **dadurch gekennzeichnet, daß** die Signalquelle (11 bis 18) ein genau definiertes, begrenztes Stromsignal liefert.

8. System nach Anspruch 6, **dadurch gekennzeichnet, daß** die Signalquelle (11 bis 18) ein zeitlich begrenztes Stromsignal, allenfalls periodisch, mit besonderem Signalverlauf oder auf Abruf, liefert.

9. System nach Anspruch 6 oder 7, **dadurch gekennzeichnet, daß** die Signalquelle (11 bis 18) einen Strombegrenzer beinhaltet.
